# EUROPEAN PATENT APPLICATION

(11) **EP 4 760 296 A1**
(43) Date of publication of application: **17.06.2026**
(21) Application number: 25861789.3
(22) Date of filing: 19.08.2025
(51) Int. Cl.: G01R 31/367, G01R 31/36, G01R 31/396

(54) **BATTERY MANAGEMENT DEVICE AND OPERATION METHOD THEREOF**

(30) Priority: 30.09.2024 KR 20240132596
(71) Applicant: LG Energy Solution, Ltd., Seoul 07335 (KR)
(72) Inventor: KIM, Jun Yeong, Daejeon 34122 (KR); KIM, Seung Hwan, Daejeon 34122 (KR)
(74) Representative: Plasseraud IP
(86) International application number: PCT/KR2025/012564
(87) International publication number: WO 2026/071482

(57) **Abstract**

A battery management device according to an embodiment disclosed herein may include a memory configured to store at least one instruction and at least one processor configured to execute the at least one instruction, and the at least one processor may identify a first reset count corresponding to a first operating state of the battery management device and diagnose a state of the battery management device based on an operating time of one or more software programs executed after the first operating state when the first reset count is greater than a reference reset count.

## Description

### TECHNICAL FIELD

### Cross-reference to Related Applications

This application claims priority from Korean Patent Application No. 10-2024-0132596, filed on September 30, 2024, the disclosure of which is incorporated by reference herein.

### Technical Field

Embodiments disclosed herein relates to a battery management device and a method of operating the same.

### BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of having a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

As the industrial fields utilizing batteries expand, a battery management system (BMS) that diagnoses the safety of batteries is also developing. The BMS may diagnose the performance of a battery utilizing various diagnostic algorithms and perform appropriate control based on the state of the battery. The BMS may diagnose the presence or absence of an abnormal battery cell. Here, "abnormality" may include all causes that may lead to ignition due to damage or aging of the battery itself.

### DISCLOSURE OF THE INVENTION

### TECHNICAL PROBLEM

Due to a problem with hardware of the BMS or software executing inside the BMS, an infinite reset state may occur in which booting for executing the BMS is endlessly repeated. When the BMS enters the infinite reset state, high current consumption occurs, which may cause the battery pack to fall into a low-voltage state.

However, in the related art, there is no technology for detecting the infinite reset state of the BMS in advance and preventing the battery pack from entering the low-voltage state.

The technical problems of the embodiments disclosed herein are not limited to those mentioned above, and other objectives not mentioned will be clearly understood by those skilled in the art from the following descriptions.

### TECHNICAL SOLUTION

According to an embodiment disclosed herein, there is provided a battery management device including a memory configured to store at least one instruction and at least one processor configured to execute the at least one instruction, in which the at least one processor is configured to identify a first reset count corresponding to a first operating state of the battery management device; and diagnose a state of the battery management device based on an operating time of one or more software programs executed after the first operating state when the first reset count is greater than a reference reset count.

In an embodiment, the processor may be configured to determine whether the operating time is less than a threshold time and diagnose the state of the battery management device based on a result of determining whether the first reset count exceeds a threshold count, when the operating time is less than the threshold time.

In an embodiment, the processor may diagnose the battery management device as being in an infinite reset state when the first reset count exceeds the threshold count.

In an embodiment, the first operating state may include a booting state in which the battery management device is booting.

In an embodiment, the processor may generate a control signal for controlling an operating state of the battery management device to be switched to a second operating state when the battery management device is diagnosed as abnormal.

In an embodiment, the second operating state may include a sleep mode state.

In an embodiment, the threshold time may be set based on a normal operating time of the software program.

According to an embodiment disclosed herein, there is provided a method of operating a battery management device, including identifying a first reset count corresponding to a first operating state of the battery management device and diagnosing a state of the battery management device based on an operating time of one or more software programs executed after the first operating state when the first reset count is greater than a reference reset count.

In an embodiment, the diagnosing may include determining whether the operating time is less than a threshold time and diagnosing the state of the battery management device based on a result of the comparing of whether the first reset count exceeds a threshold count, when the operating time is less than the threshold time.

In an embodiment, the diagnosing may include diagnosing the battery management device as being in an infinite reset state when the first reset count exceeds the threshold count.

In an embodiment, the first operating state may include a booting state in which the battery management device is booting.

In an embodiment, the method may further include generating a control signal for controlling an operating state of the battery management device to be switched to a second operating state when the battery management device is diagnosed as abnormal.

In an embodiment, the second operating state may include a sleep mode state.

In an embodiment, the threshold time may be set based on a normal operating time of the software program.

### ADVANTAGEOUS EFFECTS

A battery management device and a method of operating the same according to various embodiments disclosed herein can determine whether a BMS is in an infinite reset state based on a booting state of the BMS and the operating time of software executed after booting.

A battery management device and a method of operating the same according to various embodiments disclosed herein can prevent a battery pack from entering a low-voltage state by switching the operating state of a BMS to a sleep mode state when the BMS is diagnosed as being in an infinite reset state.

The effects of the battery management device and the method of operating the same according to the disclosure herein are not limited to the effects mentioned above, and other effects not mentioned will be clearly understood by those skilled in the art according to the disclosure herein.

### BRIEF DESCRIPTION OF THE DRAWINGS

FIG. 1 illustrates a battery pack according to an embodiment disclosed herein.
FIG. 2 is a flowchart illustrating a method of operating a battery management device according to an embodiment disclosed herein.
FIG. 3 is a flowchart illustrating operation 230 included in FIG. 2 in detail.
FIG. 4 illustrates a computing system for executing operations of the battery management device according to an embodiment disclosed herein.

With respect to the description of the drawings, the same or similar reference signs may be used for the same or similar elements.

### MODE FOR CARRYING OUT THE INVENTION

Hereinafter, embodiments of the present invention will be described with reference to the accompanying drawings. However, this is not intended to limit the present invention to the specific embodiments, and it is to be construed to include various modifications, equivalents, and/or alternatives of embodiments of the present invention.

It should be appreciated that embodiments of the present disclosure and the terms used therein are not intended to limit the technological features set forth herein to a particular embodiment and include various changes, equivalents, or replacements in corresponding embodiments. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second," "A." "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

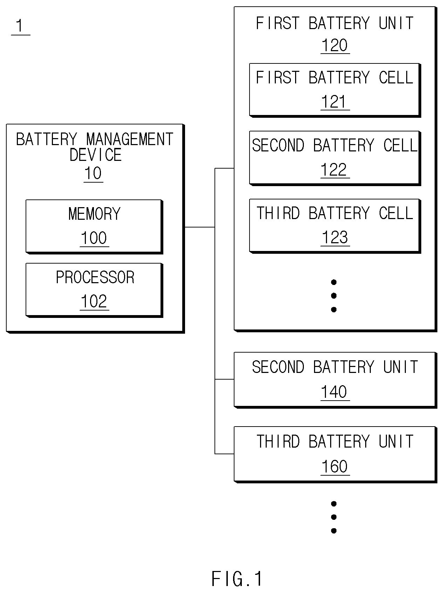

FIG. 1 illustrates a battery pack according to an embodiment disclosed herein.

Referring to FIG. 1, a battery pack 1 may be included in an electronic device. Here, the electronic device may be a mobile device (e.g., a mobile phone, a laptop computer, a smartphone, or a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

The battery pack 1 may include a battery management device 10 and battery units 120, 140, and 160. Here, each of the battery units 120, 140, and 160 may correspond to a battery module. In FIG. 1, three battery units are illustrated, but this is only for convenience of description, and the battery pack 1 may include one or more battery units. In addition, in FIG. 1, only the battery cells 121, 122, and 123 included in a first battery unit 120 are illustrated, but this is only for convenience of description, and a second battery unit 140 and a third battery unit 160 may also include a plurality of battery cells. In addition, although in FIG. 1, the number of battery cells 121, 122, and 123 included in the first battery unit 120 is illustrated as three, the number is not limited thereto, and each of the battery cells 121, 122, and 123 may be configured to include n (n is a natural number greater than or equal to 2) battery cells.

According to various embodiments, when the battery pack 1 has a cell-to-pack (CTP) structure, the battery pack 1 may be configured to include a plurality of battery cells 121, 122, and 123 without distinction between the battery units.

The battery management device 10 may obtain values (or information) related to the state of the battery units 120, 140, and 160 and the battery cells 121, 122, and 123 included therein. In an embodiment, the values related to the state may include one or more values for voltage, current, resistance, state of charge (SOC), state of health (SOH), or temperature of each of the battery units 120, 140, and 160, or a combination thereof. In an embodiment, the values related to the state may include one or more values for voltage, current, resistance, state of charge (SOC), state of health (SOH), or temperature of each of the battery cells 121, 122, and 123, or a combination thereof. Hereinafter, the values related to states may be referred to as "state values."

The battery management device 10 may be booted to execute at least one program for diagnosing the state of each of the battery units 120, 140, and 160 and/or the battery cells 121, 122, and 123. For example, when the battery pack 1 is included in an electric vehicle, turning on the electric vehicle may cause the battery management device 10 included in the battery pack 1 to execute boot software for driving the battery pack 1 to initiate booting. However, the battery management device 10 may fall into an infinite reset state in which the booting process is continuously repeated due to the hardware of the battery management device 10, software executed on the battery management device 10, or an external device. Here, the infinite reset state may include a case where the booting process is continuously repeated more than a certain number of times, a case where the software for battery diagnosis (e.g., software for SOX operation and cell voltage measurement) is not normally executed after the booting process is completed and the booting process is performed again, and the like.

In an embodiment, the battery management device 10 may be included in a battery management system (BMS) capable of diagnosing battery cells included in the electronic device, and operations performed in the battery management device 10 may be performed in the BMS. In an embodiment, the battery management device 10 may be included in a server or a charge-discharge device capable of diagnosing battery cells outside the electronic device, and operations performed in the battery management device 10 may be performed in an external server or a charge-discharge device.

Hereinafter, for convenience of description, the operations performed by each of the components included in the battery management device 10 to diagnose the battery management device 10 for any abnormality will be described.

The battery management device 10 may include a memory 100 and a processor 102. According to the embodiment, the battery management device 10 illustrated in FIG. 1 may further include at least one component (e.g., a display, an input device, or an output device) other than the components illustrated in FIG. 1.

The memory 100 may include a volatile memory or a non-volatile memory. In an embodiment, the memory 100 may store at least one instruction for executing the processor 102. The instructions, when executed by the processor 102, may cause the battery management device 10 to perform operations defined by the instructions. In an embodiment, the memory 100 may include one or more software programs. Here, the one or more software programs may include a software program for booting the battery management device 10, and one or more software programs for battery diagnosis (e.g., software programs for SOX operation and cell voltage measurement).

The processor 102 may execute at least one instruction stored in the memory 100. In an embodiment, the battery management device 10 may correspond to the BMS, and the processor 102 may correspond to or be included in a micro control unit (MCU) that performs hardware control and software operations of the BMS. The processor 102 may perform the following operations by executing at least one instruction stored in the memory 100.

The processor 102 may identify a first reset count corresponding to a first operating state of the battery management device 10. Here, the first operating state may include a state in which the battery management device 10 is booting, and the first reset count may correspond to a count for identifying whether booting is in progress for the n-th time (n is a natural number) in the first operating state. For example, when the battery management device 10 repeats booting three times, the first reset count may be identified as three.

In an embodiment, the first reset count may be identified by a watchdog timer (WDT) (not illustrated). The watchdog timer (not illustrated) may be a software timer capable of monitoring whether a particular device is normally operating and taking action accordingly. The watchdog timer (not illustrated) may monitor the infinite reset state of the battery management device 10 due to hardware and/or software errors of the battery management device 10. Software that executes the watchdog timer (not illustrated) may be stored in memory 100, and the processor 102 may execute the software to identify whether the battery management device 10 has booted or rebooted, and identify the first reset count based on the number of reboots.

In an embodiment, the reset count may be initialized back to 0 when the boot is normally completed, and in another embodiment, the reset count may have a value that accumulates with each reboot regardless of whether the boot is completed or not. The processor 102 may determine whether the battery management device 10 is in a repeated booting state by identifying the first reset count.

The processor 102 may diagnose the state of the battery management device 10 based on the operating time of one or more software programs executed after the first operating state when the first reset count is greater than a reference reset count. Here, the reference reset count may be arbitrarily set by a setter. For example, when the reference reset count is set to one, and the booting process of the battery management device 10 is performed twice, the first reset count may be identified as two. In this case, the processor 102 may determine that the first reset count exceeds the reference reset count and may proceed with the following steps to determine whether an infinite reset is performed.

In an embodiment, the processor 102 may determine whether the operating time is less than a threshold time. According to an embodiment, the operating time may be the time during which each of the software programs for battery diagnosis (e.g., SOX operation and voltage measurement) is executed in addition to the time during which the battery management device 10 boots. In addition, the threshold time may be set based on the time during which each of one or more software programs normally operates. In an embodiment, the threshold time may be set by adding an initial time (init time) for each of one or more software programs to a time taken for m repetitions (m is a natural number) of the longest period in the main loop. In an embodiment, the threshold time may be set based on the period of a function (e.g., a SOX calculation function) corresponding to the longest period among a plurality of functions that are repeated at regular intervals included in a particular software program. For example, when the period of the SOX calculation function is one second, the threshold time may be set to ten seconds, which is ten times the period of the SOX calculation function. The processor 102 may determine whether the one or more software programs stored in the memory 100 normally operate after the booting of the battery management device 10 is completed by comparing the operating time and a threshold value. Even when the battery management device 10 has normally completed booting, when the operating time of the software is less than the threshold time, the processor 102 may diagnose the state of the battery management device 10 as rebooted.

In an embodiment, the processor 102 may determine whether the first reset count exceeds the threshold count when the operating time is less than the threshold time. The processor 102 may diagnose the state of the battery management device 10 based on the result of determining whether the first reset count exceeds the threshold count when the operating time is less than the threshold time. The processor 102 may diagnose the battery management device 10 as being in the infinite reset state when the first reset count exceeds the threshold count. Here, the threshold count may be set by the setter to prevent the battery management device 10 from being misdiagnosed as the infinite reset state even though it is normally booting. For example, the threshold count may be set to 100, and when the first reset count exceeds the threshold count of 100, the processor 102 may diagnose the battery management device 10 as being in the infinite reset state.

The processor 102 may generate a control signal for controlling an operating state of the battery management device 10 to be switched to a second operating state when the battery management device 10 is diagnosed as abnormal (e.g., diagnosed as being in the infinite reset state). Here, the second operating state may include a sleep mode state in which the battery management device 10 stops operating. The processor 102 may prevent a low-voltage state of the battery pack 1 that may occur due to power consumption of the battery pack 1 caused by the infinite reset state by switching the operating state of the battery management device 10 to the sleep mode state when the battery management device 10 is diagnosed as abnormal.

In an embodiment, the processor 102 may include a central processing unit, an application processor, a graphics processing unit, a neural processing unit (NPU), an image signal processor, a sensor hub processor, or a communication processor. In an embodiment, the processor 102 may execute software to control at least one other component (e.g., a hardware or software component) of the battery management device 10 coupled to the processor 102 and perform various data processing or computation.

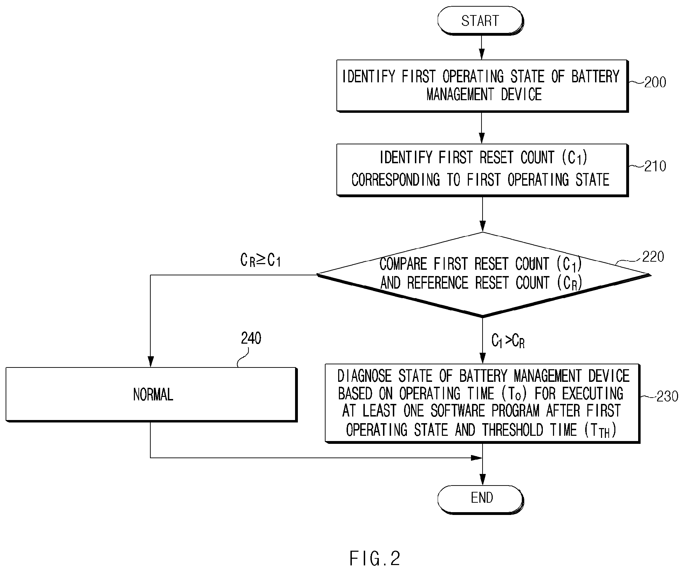

FIG. 2 is a flowchart illustrating a method of operating a battery management device according to an embodiment disclosed herein.

Referring to FIG. 2, in operation 200, the processor 102 may identify a first operating state of the battery management device 10. Here, the first operating state may include a state in which the battery management device 10 is booting.

In operation 210, the processor 102 may identify a first reset count C₁ corresponding to the first operating state. Here, the first reset count C₁ may correspond to a count for identifying whether booting is in progress for the n-th time (n is a natural number) in the first operating state.

In operation 220, the processor 102 may compare the first reset count C₁ and a reference reset count C_{R}.

In operation 230, the processor 102 may diagnose the state of the battery management device based on the operating time during which at least one software program is executed after the first operating state and a threshold time when the first reset count C₁ exceeds the reference reset count C_{R} (operation 220, C_{R} ≥ C₁).

In operation 240, the processor 102 may diagnose the booting process of the battery management device 10 as normal when the first reset count C₁ is less than or equal to the reference reset count C_{R} (operation 220, C₁ > C_{R}).

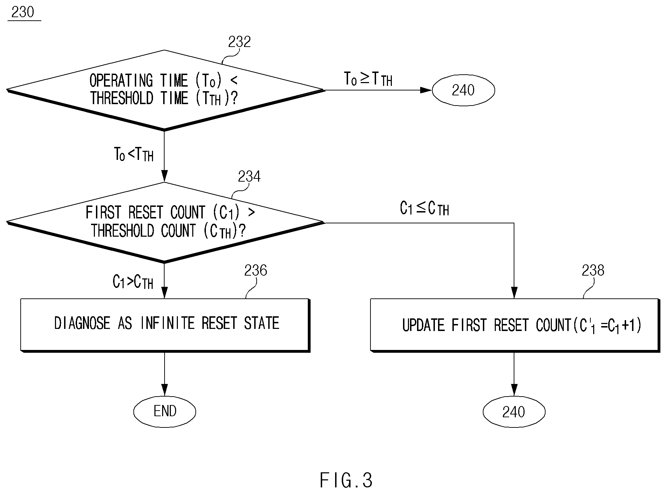

FIG. 3 is a flowchart illustrating operation 230 included in FIG. 2 in detail.

Referring to FIG. 3, operation 230 included in FIG. 2 may include operations 232 to 238.

In operation 232, the processor 102 may determine whether an operating time T_{O} is less than a threshold time T_{TH}. When the operating time T_{O} is greater than or equal to the threshold time T_{TH} (operation 232, T_{O} ≥ T_{TH}), the processor 102 may return to operation 240 and diagnose the battery management device 10 as being in a normal operating state.

In operation 234, the processor 102 may determine whether the first reset count C₁ exceeds a threshold count C_{TH} when the operating time T_{O} is less than the threshold time T_{TH} (operation 232, T_{O} < T_{TH}).

In operation 236, the processor 102 may diagnose the battery management device 10 as being in the infinite reset state when the first reset count C₁ exceeds the threshold count C_{TH} (operation 234, C₁ > C_{TH}).

According to the embodiment, when the battery management device 10 is diagnosed as being in the infinite reset state, the processor 102 may generate a control signal for switching the operating state of the battery management device 10 to a sleep mode state.

In operation 238, the processor 102 may update the first reset count by increasing the reset count when the first reset count C₁ is less than or equal to the threshold count C_{TH} (C₁ ≤ C_{TH}). For example, when the first reset count is C₁, the updated first reset count C'₁ may be C₁+1. The processor 102 may return to operation 240 after updating the first reset count and diagnose the battery management device 10 as being in a normal operating state.

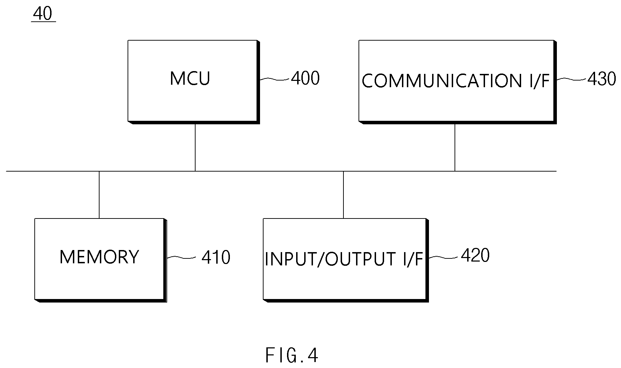

FIG. 4 illustrates a computing system that executes operations of the battery management device according to an embodiment disclosed herein.

Referring to FIG. 4, a computing system 40 according to an embodiment disclosed herein may include a microcontroller unit (MCU) 400, a memory 410, an input/output interface (I/F) 420, and a communication I/F 430.

The MCU 400 may be a processor that executes various programs (e.g., a battery diagnosis program) stored in the memory 410, processes various data from the programs, and performs functions of the battery management device 10 illustrated in FIGS. 1 to 3 described above.

The memory 410 may store various programs related to the operations of the battery management device 10. In addition, the memory 410 may store operating data of the battery management device 10.

A plurality of memories 410 may be provided as needed. The memory 100 may be a volatile memory or a non-volatile memory. As the volatile memory for the memory 410, a random-access memory (RAM), a dynamic RAM (DRAM), a static RAM (SRAM), or the like may be used. As the non-volatile memory for the memory 410, a read-only memory (ROM), a programmable ROM (PROM), an electrically alterable ROM (EAROM), an erasable programmable ROM (EPROM), an electrically erasable programmable ROM (EEPROM), a flash memory, or the like may be used. The memories 100 listed above are only exemplary and are not limited to the examples.

The input/output I/F 420 may provide an interface that connects an input device (not shown) such as a keyboard, a mouse, a touch panel, or the like, and an output device such as a display (not shown), to the MCU 400 to enable data transmission and reception.

The communication I/F 430 is a component that may transmit and receive various data to and from the server, and may be any device that may support wired or wireless communication. For example, a program for abnormal diagnosis or various data (e.g., state values) may be transmitted to and received from a separately provided external server through the communication I/F 430.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. A battery management device comprising:
a memory configured to store at least one instruction; and
at least one processor configured to execute the at least one instruction,
wherein the at least one processor is configured to:
identify a first reset count corresponding to a first operating state of the battery management device; and
diagnose a state of the battery management device based on an operating time of one or more software programs executed after the first operating state when the first reset count is greater than a reference reset count.

2. The battery management device of claim 1, wherein the processor is configured to:
determine whether the operating time is less than a threshold time; and
diagnose the state of the battery management device based on a result of determining whether the first reset count exceeds a threshold count, when the operating time is less than the threshold time.

3. The battery management device of claim 2, wherein the processor diagnoses the battery management device as being in an infinite reset state when the first reset count exceeds the threshold count.

4. The battery management device of claim 1, wherein the first operating state includes a booting state in which the battery management device is booting.

5. The battery management device of claim 4, wherein the processor generates a control signal for controlling an operating state of the battery management device to be switched to a second operating state when the battery management device is diagnosed as abnormal.

6. The battery management device of claim 5, wherein the second operating state includes a sleep mode state.

7. The battery management device of claim 1, wherein the threshold time is set based on a normal operating time of the software program.

8. A method of operating a battery management device, comprising:
identifying a first reset count corresponding to a first operating state of the battery management device; and
diagnosing a state of the battery management device based on an operating time of one or more software programs executed after the first operating state when the first reset count is greater than a reference reset count.

9. The method of claim 8, wherein the diagnosing includes:
determining whether the operating time is less than a threshold time; and
diagnosing the state of the battery management device based on a result of the comparing of whether the first reset count exceeds a threshold count, when the operating time is less than the threshold time.

10. The method of claim 9, wherein the diagnosing includes diagnosing the battery management device as being in an infinite reset state when the first reset count exceeds the threshold count.

11. The method of claim 8, wherein the first operating state includes a booting state in which the battery management device is booting.

12. The method of claim 11, further comprising generating a control signal for controlling an operating state of the battery management device to be switched to a second operating state when the battery management device is diagnosed as abnormal.

13. The method of claim 12, wherein the second operating state includes a sleep mode state.

14. The method of claim 8, wherein the threshold time is set based on a normal operating time of the software program.
